# EUROPÄISCHE PATENTSCHRIFT

(11) **EP 2 951 927 B1**
(45) Veröffentlichungstag und Bekanntmachung des Hinweises auf die Patenterteilung: **12.04.2017**
(21) Anmeldenummer: 14720883.9
(22) Anmeldetag: 24.01.2014
(51) Int. Cl.: H03M 13/13, H03M 13/43

(54) **PARALLELISIERTE MAJORITY-LOGIC DEKODIERUNG VON REED-MULLER KODES**
PARALLELIZED MAJORITY-LOGIC DECODING OF REED-MULLER CODES
DÉCODAGE PARALLELISÉ À VOTE MAJORITAIRE DE CODES REED-MULLER

(30) Priorität: 01.02.2013 DE 102013001740
(43) Veröffentlichungstag der Anmeldung: 09.12.2015
(73) Patentinhaber: Eberhard Karls Universität Tübingen, 72074 Tübingen (DE)
(72) Erfinder: BERTRAM, Juliane, 74321 Bietigheim-Bissingen (DE); HUBER, Michael, 72070 Tübingen (DE); HAUCK, Peter, 72336 Balingen (DE)
(74) Vertreter: Patentanwälte Ruff, Wilhelm, Beier, Dauster & Partner mbB
(86) Internationale Anmeldenummer: PCT/DE2014/000027
(87) Internationale Veröffentlichungsnummer: WO 2014/117764

(56) Entgegenhaltungen:
- US-A1- 2002 053 062
- BERTRAM JULIANE ET AL: "An Improved Majority-Logic Decoder Offering Massively Parallel Decoding for Real-Time Control in Embedded Systems", IEEE TRANSACTIONS ON COMMUNICATIONS, IEEE SERVICE CENTER, PISCATAWAY, NJ. USA, Bd. 61, Nr. 12, 1. Dezember 2013 (2013-12-01), Seiten 4808-4815, XP011534895, ISSN: 0090-6778, DOI: 10.1109/TCOMM.2013.102413.130109 [gefunden am 2013-12-19]
- CHIN-LONG CHEN: "On majority-logic decoding of finite geometry codes", IEEE TRANSACTIONS ON INFORMATION THEORY, Bd. 17, Nr. 3, 1. Mai 1971 (1971-05-01), Seiten 332-336, XP002726723, ISSN: 0018-9448, DOI: 10.1109/TIT.1971.1054629 in der Anmeldung erwähnt
- LIN S ET AL: "Error Control Coding: Fundamentals and Applications, FINITE GEOMETRY CODES", 1. Januar 1983 (1983-01-01), ERROR CONTROL CODING. FUNDAMENTALS AND APPLICATIONS, ENGLEWOOD CLIFFS, PRENTICE HALL, US, PAGE(S) 233 - 256, XP002390634, in der Anmeldung erwähnt Seite 249 - Seite 253 Abbildung 8.2
- REED I: "A class of multiple-error-correcting codes and the decoding scheme", IRE PROFESSIONAL GROUP ON INFORMATION THEORY, IEEE, PISCATAWAY, NJ, USA, Bd. 4, Nr. 4, 1. September 1954 (1954-09-01), Seiten 38-49, XP011461957, ISSN: 2168-2690, DOI: 10.1109/TIT.1954.1057465 in der Anmeldung erwähnt

## Beschreibung

Die vorliegende Erfindung betrifft eine Anordnung und ein Verfahren zur Decodierung eines Digitalsignals, im Folgenden *Datenwort* genannt.

Derartige Anordnungen und Verfahren werden in der Nachrichtenübertragung und Datenspeicherung zur Rekonstruktion einer als Analog- oder Digitalsignal übertragenen Nachricht, im Folgenden *Codewort* genannt, eingesetzt.

Ein Codewort ist eine Datenabfolge, die durch Hinzufügen von Redundanz zu einer *Information* nach einer gegebenen Vorschrift, im Folgenden *Code* genannt, erzeugt wird.

Eine Informationsquelle wie etwa ein Speicherelement oder ein Sender überträgt mittels eines Kanals ein Codewort an einen Empfänger. Ist dieser Kanal verrauscht, kann das Codewort beschädigt werden. Das Datenwort und das Codewort sind dann verschieden.

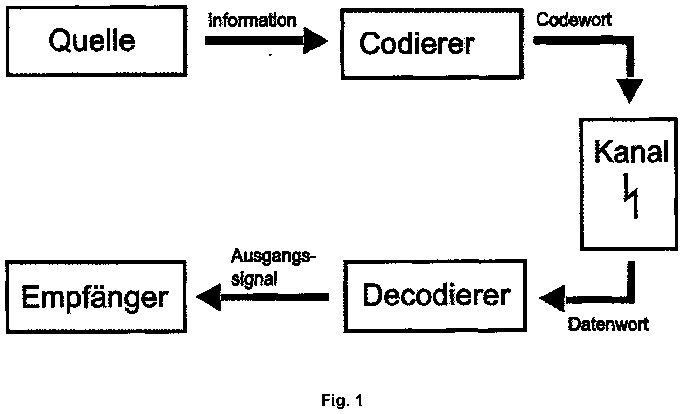

Der Decodierer erzeugt mit Hilfe des Datenworts ein Ausgangssignal (**Fig. 1**). Dieses Ausgangssignal kann das Codewort, die Information oder Teile des Codeworts bzw. der Information beinhalten.

Bei dem erfindungsgemäßen Decodierverfahren handelt es sich um eine fehlerkorrigierende Maßnahme, um das Codewort oder die Information oder Teile davon mit Hilfe des Datenworts zu ermitteln. Hierbei wird ausgenutzt, dass die Information im Codewort redundant hinterlegt ist.

Ein Codewort und ein Datenwort bestehen jeweils aus N Symbolen. Die Information besteht aus *K* Symbolen. Bei einer *systematischen* Codierung besteht das Codewort aus der Information und einer Redundanz-Datenabfolge, sodass die Information direkt aus dem Codewort ablesbar ist. Bei einer nicht-systematischen Codierung ist die Information nicht direkt aus dem Codewort ablesbar.

Der Code definiert zudem die sogenannte Minimaldistanz D. Wenn die Anzahl der bei der Übertragung beschädigten Symbole maximal (D-1)/2 ist, kann ein geeigneter Decodierer das Codewort oder die Information oder Teile davon eindeutig rekonstruieren.

Die Reed-Muller-Codes sind eine Familie von linearen, fehlerkorrigierenden Codes. Sofern der verwendete Decoder dies unterstützt, ermöglicht die Struktur der Reed-Muller-Codes sowohl die gesamte Information als auch Teile der Information sehr schnell zu decodieren. Außerdem erlauben Reed-Muller-Codes einen breiten Einsatz für verschiedene Anwendungen, da die Blocklänge N und die Anzahl, wie viele Fehler korrigiert werden können auf die jeweilige Anwendung zugeschnitten werden können.

Diese Klasse von Codes wurde 1954 von Irving S. Reed und David E. Muller entwickelt(1), (2). Der binäre Reed-Muller-Code wurde von der NASA in den Mariner Expeditionen (1969 bis 1976) zum Mars benutzt, um die vom Mars gemachten Fotos an die Erde zu senden.

Die Reed-Muller-Codes wurden in letzter Zeit weniger verwendet, weil ihre Informationsraten in der Regel geringer sind als bei anderen Klassen von Codes. Da ihre Struktur eine parallele Decodierung der Information ermöglicht, ist diese Klasse von Codes für Multicore-Anwendungen zunehmend interessant.

Verschiedene Arten der Decodierung können mitunter auch kombiniert auf dieser Code-Klasse angewandt werden: z.B. Hard-Decision-Decoder basierend auf Majority-Logic bei (2), (6), (7) oder rekursive Soft-Decision-Decoder, z.B. bei (3), (4).

Die *Majority-Logic-Decodierung* (*Mehrheitsdecodierung*) beinhaltet mehrere Stufen von Mehrheitsentscheidungen. Bei einer Mehrheitsentscheidung wird der Wert übermittelt, der am häufigsten vorkommt. Diese Art der Decodierung hat den Vorteil, dass sie sehr einfach und vor allem auf der Hardware-Ebene implementiert werden kann. Zudem ist die Mehrheitsdecodierung sehr schnell. Im Gegensatz zu Decodierungen, die die mitunter zyklische oder rekursiv aufgebaute Struktur eines Codes ausnutzen, ist bei der Mehrheitsdecodierung ein paralleles Decodieren der gesamten Information möglich, sodass die Decodierzeit verkürzt werden kann.

Der Reed-Algorithmus (2) ist ein Majority-Logic-Hard-Decision-Decodierverfahren für Reed-Muller-Codes. Dieser Algorithmus besteht aus (R+1) Ebenen von Mehrheitsentscheidungen, wobei R mit steigender Informationslänge K bei gleichbleibender Blocklänge N wächst. Reeds Verfahren benötigt daher eine Vielzahl von Entscheidungsmodulen und kann nicht in konstanter paralleler Zeit decodieren.

In dem bei Dumer (3) beschriebenen Verfahren wird rekursiv decodiert, indem wenige jedoch sequenziell aufeinander aufbauende Rechenschritte durchgeführt werden. Dies hat eine verlängerte Decodierzeit zur Folge, da keine Berechnungen parallel ausgeführt werden können. Außerdem lässt sich dieses Verfahren nur mit komplexeren oder einer Vielzahl von Bauteilen auf Hardware-Ebene realisieren, da es mit Festkommazahlen arbeitet.

In der Patentschrift WO0176077 A2 wird ein Decodierschema vorgestellt, das den Fokus auf das serielle Decodieren mit Auffangregistern legt. Die einzelnen Bits werden mit Hilfe von Schaltnetzen, die mitunter Majority-Gatter enthalten, decodiert. Konkrete Rechenschritte für die Decodierung werden nicht angeführt, stattdessen wird auf etablierte Verfahren verwiesen, die in (5) beschrieben sind.

Lin und Costello beschreiben in (5) detailliert den Stand der Technik hinsichtlich der Decoder für Reed-Muller-Codes. Alle dort aufgeführten Decoder benötigen wesentlich mehr Majority-Gatter zum Decodieren. Im Besonderen erwähnen Lin und Costello auch das Verfahren von Chen (6), (7), welches von den in (5) präsentierten parallelen Decodern die wenigsten Majority-Gatter benötigt.

Das von Chen beschriebene Verfahren (6), (7) lässt sich in Hardware umsetzen, allerdings mit mehr Bauteilen und einem erhöhten Platzbedarf. Im Besonderen sind mehr Mehrheitsentscheidungen zu treffen.

Die Patentschrift US5926488 A beansprucht eine Decodierung nur für Reed-Muller-Codes der zweiten Ordnung, bei denen R = 2 gilt. Das dort vorgestellte Verfahren ist ebenfalls ein rekursives Verfahren, welches für die Realisierung eine Vielzahl von Bauteilen benötigt.

In dem Patent US7331012 B2 wird ein System zum Decodieren von Reed-Mullercodierten Signalen beansprucht. Der Decoder besteht im Kern aus einem Soft-Decision-Algorithmus, der auf dem Reed-Algorithmus basiert.

Die Aufgabe der vorliegenden Erfindung ist daher, eine Anordnung und ein Verfahren zur effizienten parallelen Echtzeitdecodierung (Fehlererkennung und -korrektur) von einem Datenwort bereitzustellen, deren Realisierung in Hardware möglich ist und im Vergleich zum Stand der Technik mit einer einfacheren Architektur und weniger Bauteilen realisierbar ist.

Diese Aufgabe wird durch eine Anordnung mit den Merkmalen des Anspruchs 1 gelöst.

Der in der vorliegenden Erfindung verwendete lineare Code ist ein binärer Reed-Muller-Code oder ein ihm äquivalenter Code. N bezeichne die Länge, D den Abstand und K die Dimension des Codes. Weiterhin seien E und F wie folgt definiert: E=D-2 und F=N/D. Die natürliche Zahl G beschreibe, wie viele der N Symbole des Datenworts korrigiert werden sollen. Es beschreibe H eine natürliche Zahl zwischen 1 und E•D.

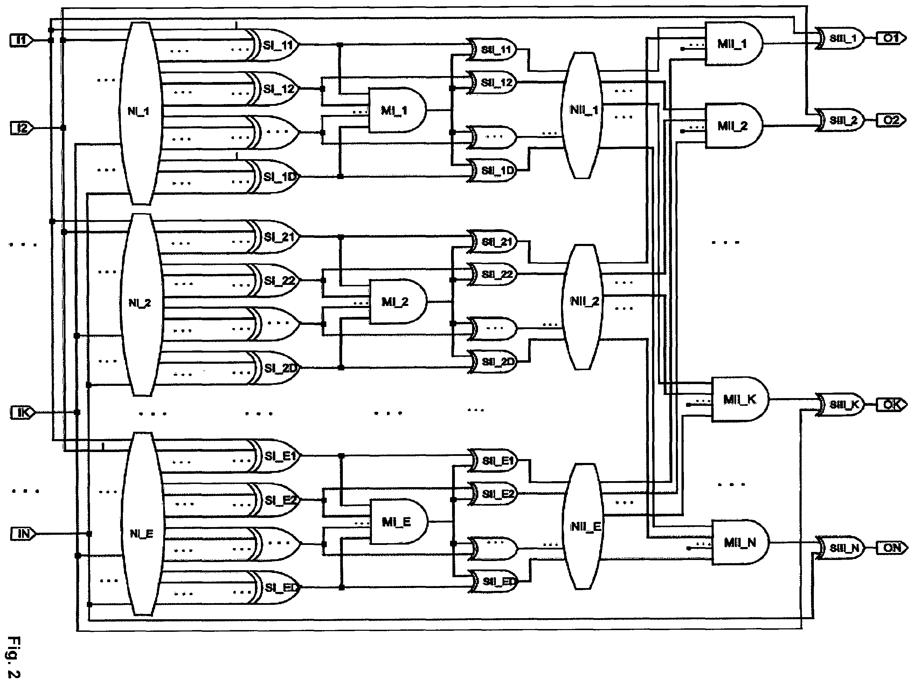

Die erfindungsgemäße Anordnung besteht aus folgenden Bauteilen **(****Fig. 2****):**
a. N Eingangsanschlüsse I1 bis IN,
b. eine erste Ebene von E•D Summiermodulen, SI_11 bis SI_ED, wobei jedes Summiermodul der ersten Ebene mit F verschiedenen Eingangsanschlüssen und jeder Eingangsanschluss mit E Summiermodulen der ersten Ebene verknüpft ist,
c. eine erste Ebene von E Entscheidungsmodulen, MI_1 bis MI_E, wobei jeder der D Eingänge jedes Entscheidungsmoduls mit jeweils einem Ausgang aus D verschiedenen Summiermodulen aus der ersten Ebene der Summiermodule verknüpft ist,
d. eine zweite Ebene von H Summiermodulen, SII_1 bis SII_H, wobei jedes Summiermodul mit einem Entscheidungsmodul aus der ersten Ebene der Entscheidungsmodule und einem Summiermodul aus der ersten Ebene der Summiermodule verknüpft ist,
e. eine zweite Ebene von G Entscheidungsmodulen, MII_1 bis MII_G, wobei jeder der E Eingänge jedes Entscheidungsmoduls mit jeweils einem Ausgang aus E verschiedenen Summiermodulen aus der zweiten Ebene der Summiermodule verknüpft ist,
f. eine dritte Ebene von G Summiermodulen, SIII_1 bis SIII_G, wobei jedes Summiermodul mit genau einem Entscheidungsmodul aus der zweiten Ebene der Enscheidungsmodule und einem Eingangsanschluss verknüpft ist,
g. G Ausgangsanschlüsse, O1 bis OG, wobei jeder Ausgangsanschluss mit genau einem Summiermodul aus der dritten Ebene der Summiermodule verknüpft ist.
h. Die konkrete Vernetzung NI_1 bis NI_E der N Eingangsanschlüsse I1 bis IN mit den Summiermodulen der ersten Ebene SI_11 bis SI_ED sowie die konkrete Vernetzung NII_1 bis NII_E der Summiermodule der zweiten Ebene SII_11 bis SII_ED mit den Entscheidungsmodulen der zweiten Ebene MII_1 bis MII_G hängt vom konkreten Code ab.

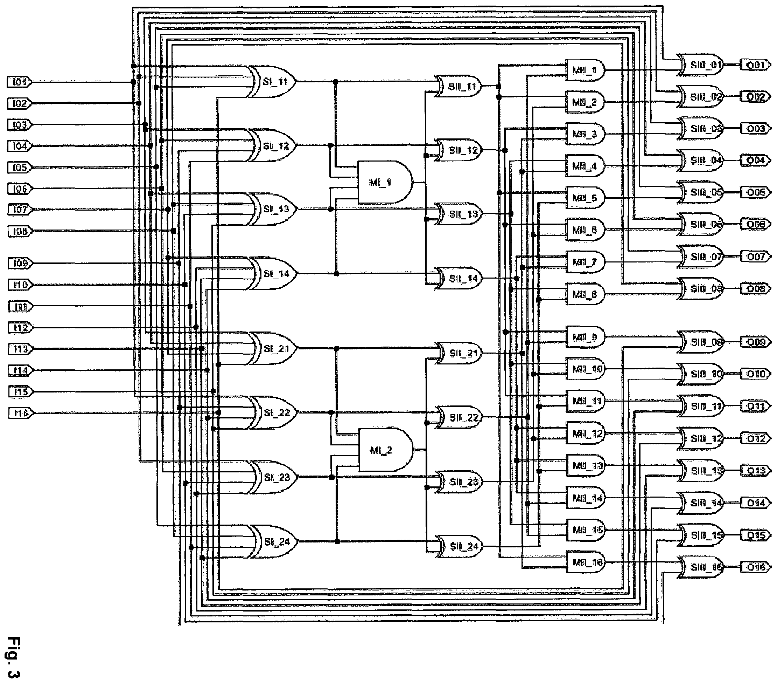

Beispielhaft wird die Anordnung der Schaltnetze NI_1 bis NI_E und NII_1 bis NII_E für den Reed-Muller-Code RM(2,4) dargestellt und beschrieben (Fig. 3). Mit Hilfe der erläuternden Beschreibung anhand des Ausführungsbeispiels RM(2,4) ist für den Fachmann auf dem Gebiet klar ersichtlich, wie die Anordnungen bei anderen Codes zu konstruieren sind.

Vorzugsweise ist G=N oder G=K, sodass entweder das gesamte Codewort oder ausschließlich die gesamte Information wiederhergestellt werden kann. Besonders bevorzugt ist H gleich E•D.

Die in den Summiermodulen auszuführenden Additionsoperationen entsprechen XOR-Operationen. Die Summiermodule der ersten Ebene (2) können auf Hardware-Ebene durch Odd-Parity-Gatter realisiert werden. Die Summiermodule der zweiten Ebene (4) und der dritten Ebene (6) können im Fall eines binären Codes durch XOR-Gatter umgesetzt werden. Für die Entscheidungsmodule der ersten Ebene (3) und zweiten Ebene (5) können Majority-Gatter verwendet werden. Ist E gleich 2, so kann für das Entscheidungsmodul ein AN D-Gatter verwendet werden.

Ferner betrifft die vorliegende Erfindung das Verfahren zur Decodierung eines Datenworts mit Hilfe eines fehlerkorrigierenden, linearen Codes. Es gibt, wenn man die Anzahl der übergebenen Symbole vernachlässigt, zwei Arten von Modulen, die parallel oder sequenziell ausgeführt werden können: I) Summiermodule addieren alle ihnen übergebenen Symbole binär auf und geben die Summe, also eins oder null, zurück; II) Entscheidungsmodule überprüfen auf Häufigkeit der ihm übergebenen Symbole und liefern jenes Symbol zurück, welches am häufigsten auftritt.

Das erfindungsgemäße Verfahren beinhaltet folgende Schritte, wobei die Parameter N, E, D, F und G wie oben definiert sind:
(1) das Einlesen des Datenworts, bestehend aus N Symbolen;
(2) das parallele Bilden von E•D Summen, wobei jede Summe aus F verschiedenen Symbolen des Datenworts aus (1) mit Hilfe eines Summiermoduls gebildet wird und jedes Symbol des Datenworts aus (1) zur Summenbildung von E Summen herangezogen wird;
(3) das parallele Ermitteln von E Entscheidungswerten, wobei jeder Entscheidungswert auf Basis von D durch verschiedene Summiermodule gebildete Summen aus (2) mit Hilfe eines Entscheidungsmoduls ermittelt wird und jede Summe aus (2) zur Ermittlung eines Entscheidungswerts herangezogen wird;
(4) das parallele Bilden von H Summen, wobei jede Summe aus einem der E Entscheidungswerte aus (3) und einer der E•D Summen aus (2) gebildet wird;
(5) das parallele Ermitteln von G Entscheidungswerten, wobei jeder Entscheidungswert auf Basis von E durch verschiedene Summiermodule gebildete Summen aus (4) mit Hilfe eines Entscheidungsmoduls ermittelt wird;
(6) das parallele Bilden von G Summen, wobei jede Summe aus einem der G Entscheidungswerte aus (5) und einem der N Symbole des Datenworts aus (1) gebildet wird;
(7) das Ausgeben der in (6) erzeugten Summen,
   wobei N die Länge des Codes und D den Minimalabstand des Codes bezeichnen, E gleich D-2 ist, F gleich N/D ist und G die Anzahl der zu korrigierenden Symbole des Datenworts bezeichnet.

Die erfindungsgemäße Anordnung hat den großen Vorteil, dass die zugrundeliegende Architektur ein Schaltnetz und keinen Schaltkreis darstellt, wie vom Stand der Technik bekannt, und mit wenigen einfachen Bauteilen aufgebaut werden kann. Es werden z.B. keine Register- bzw. Speicherelemente, keine Flip-Flops oder Taktgeber benötigt. Im Vergleich zum herkömmlichen Decodierverfahren des Reed-Muller-Codes werden erfindungsgemäß nur zwei Ebenen von Entscheidungsmodulen mit insgesamt nicht mehr als G+E Entscheidungsmodulen verwendet. Dadurch spart man nicht nur Bauteile und Platz, sondern verkürzt auch die Decodierzeit, so dass durch paralleles Decodieren in Echtzeit alle Fehler korrigiert werden können.

Weitere Vorteile, Merkmale und Anwendungsmöglichkeiten der Erfindung werden nachstehend anhand des unten beschriebenen Ausführungsbeispiels mit Bezug auf die Figuren beschrieben.

**Fig 1****:** Allgemeines Schema zur Kanalcodierung und -decodierung. Die Quelle (etwa ein Sender oder ein Speicherregister) überträgt die Information an den Codierer. Im Codierer wird ein Codewort erzeugt, indem die Information vervielfältigt wird. Das Codewort wird über einen Kanal übertragen. Das Codewort kann beim Übertragen durch den Kanal beschädigt werden. Das mitunter beschädigte Codewort, als Datenwort bezeichnet, wird an den Decodierer weitergeleitet. Im Decodierer wird das Ausgangssignal mittels des Datenworts erzeugt. Je nach Ausführungsbeispiel kann das Ausgangssignal das gesamte Codewort, die ursprüngliche Information oder ein Teil des Codeworts bzw. der Information beinhalten.

**Fig. 2****:** Ein Ausführungsbeispiel der erfindungsgemäßen Anordnung zur Decodierung unter Verwendung eines binären Reed-Muller-Codes RM(r,m), bei dem G=N und H =E•D ist. Die Anordnung ist in sieben Ebenen aufgeteilt: (1) N Eingangsanschlüsse, (2) E•D Summiermodule, (3) E Entscheidungsmodule, (4) E•D Summiermodule, (5) N Entscheidungsmodule, (6) N Summiermodule, (7) N Ausgangsanschlüsse. Die Signale der Eingangsanschlüsse (1) werden mittels der Schaltnetze NI_1 bis NI_E an die Summiermodule SI_11 bis SI_ED (2) übertragen. Die Summiermodule (2) addieren die Signale auf und geben die Summe aus. Die Summen werden an die Entscheidungsmodule MI_1 bis MI_E (3) geleitet. Jedes Entscheidungsmodul (3) gibt jene Summe aus, die es am häufigsten empfängt. In den Summiermodulen SII_11 bis SII_ED (4) wird diese mehrheitlich empfangene Summe zu den zuvor in den Summiermodulen (2) berechneten Summen addiert. Die durch die Summiermodule (4) ausgegebenen Signale werden durch die Schaltnetze NII_1 bis NII_E an die Entscheidungsmodule MII_1 bis MII_N (5) weitergeleitet. Jedes Entscheidungsmodul (5) gibt jenes Signal aus, das es am häufigsten empfängt. Die durch die Entscheidungsmodule (5) ausgegebenen Signale werden an die Summiermodule SIII_1 bis SIII_N (6) weitergeleitet. In den Summiermodulen (6) werden die Signale der Eingangsanschlüsse (1) und die von den Entscheidungsmodule (5) ausgegebenen Signale aufaddiert und an die Ausgangsanschlüsse O1 bis ON weitergeleitet. Sind höchstens (D-1)/2 Symbole des Datenworts bei der Übertragung beschädigt worden, so entspricht die Gesamtheit der an den Ausgangsanschlüssen vorliegenden Signale dem Codewort.

**Fig. 3****:** Ein Ausführungsbeispiel der erfindungsgemäßen Anordnung zur Decodierung unter Verwendung eines binären Reed-Muller-Codes RM(2,4). Es gilt N=16, K=11, D=4; E=2, F=4, G=16 und H = 8 ist. Die Anordnung ist in sieben Ebenen aufgeteilt: (1) 16 Eingangsanschlüsse; (2) 8 Summiermodule, die jeweils ausgeben, ob die Summe der Symbole der verknüpften Eingangsanschlüsse gerade oder ungerade ist; (3) 2 Entscheidungsmodule, (4) 8 Summiermodule, (5) 16 Entscheidungsmodule, (6) 16 Summiermodule, (7) 16 Ausgangsanschlüsse. Je 4 Signale der Eingangsanschlüsse (1) werden an jedes Summiermodul SI_11 bis SI_24 (2) übertragen. Die Summiermodule (2) addieren die Signale binär auf und geben die Summe, welche entweder 0 oder 1 ist, aus. Die Summen werden an die Entscheidungsmodule MI_1 und MI_2 (3) geleitet. Jedes Entscheidungsmodul (3) gibt jene Summe aus, die es am häufigsten empfängt. In den Summiermodulen SII_11 bis SII_ED (4) wird diese mehrheitlich empfangene Summe zu den zuvor in den Summiermodulen (2) berechneten Summen addiert. Die durch die Summiermodule (4) ausgegebenen Signale werden durch an die Entscheidungsmodule MII_1 bis MII_16 (5) weitergeleitet. Jedes Entscheidungsmodul (5) gibt jenes Signal aus, das es am häufigsten empfängt. Die durch die Entscheidungsmodule (5) ausgegebenen Signale werden an die Summiermodule SIII_1 bis SIII_16 (6) weitergeleitet. In den Summiermodulen (6) werden die Signale der Eingangsanschlüsse (1) und die von den Entscheidungsmodule (5) ausgegebenen Signale aufaddiert und an die Ausgangsanschlüsse O1 bis 016 weitergeleitet. Ist höchstens ein Symbol des Datenworts bei der Übertragung beschädigt worden, so entspricht die Gesamtheit der an den Ausgangsanschlüssen vorliegenden Signale dem Codewort.

### Ausführungsbeispiel

Wird mit dem binären Reed-Muller-Coder RM(2,4) codiert, so gilt: N=16, D=4, K=11, E=2, F=4. Soll das gesamte Codewort aus dem Datenwort rekonstruiert werden, so ist G=16.

Die erfindungsgemäße Anordnung besteht dann aus folgenden Bauteilen (siehe **Fig. 3****):**
a. 16 Eingangsanschlüsse I01 bis I16,
b. eine erste Ebene von acht Summiermodulen, S_11 bis S_24, wobei jeder Eingangsanschluss mit zwei Summiermodulen der ersten Ebene und jedes Summiermodul der ersten Ebene mit vier verschiedenen Eingangsanschlüssen verknüpft ist,
c. eine erste Ebene von zwei Entscheidungsmodule, MI_1 bis MI_2, wobei jedes Entscheidungsmodul mit 4 Summiermodulen aus der ersten Ebene der Summiermodule verknüpft ist,
d. eine zweite Ebene von acht Summiermodulen, SII_11 bis SII_24, wobei jedes Summiermodul mit einem Entscheidungsmodul aus der ersten Ebene der Entscheidungsmodule und einem Summiermodul aus der ersten Ebene der Summiermodule verknüpft ist,
e. eine zweite Ebene von 16 Entscheidungsmodulen, MII_01 bis MII_16, wobei jedes Entscheidungsmodul mit zwei Summiermodulen aus der zweiten Ebene der Summiermodule verknüpft ist,
f. eine dritte Ebene von G Summiermodulen, SIII_01 bis SIII_16, wobei jedes Summiermodul mit genau einem Entscheidungsmodul aus der zweiten Ebene der Enscheidungsmodule und einem Eingangsanschluss verknüpft ist,
g. G Ausgangsanschlüsse, O01 bis 016, wobei jeder Ausgangsanschluss mit genau einem Summiermodul aus der dritten Ebene der Summiermodule verknüpft ist.
h. Um die konkrete Vernetzung, NI_1 bis NI_2, der 16 Eingangsanschlüsse, I1, bis 116, mit den Summiermodulen der ersten Ebene, SI_11 bis SI_24, sowie die konkrete Vernetzung, NII_1 bis NII_2, der Summiermodule der zweiten Ebene, SII_11 bis SII_24, mit den Entscheidungsmodulen der zweiten Ebene, MII_1 bis MII_N, zu bestimmen, sind einige mathematische Betrachtungen notwendig.

Sei GF(2) der Körper mit zwei Elementen, bezeichnet mit 1 und 0. Im Besonderen gilt: 1+1=0 Sei V:={(v1,v2,v3,v4) | v1,v2,v3,v4 in GF(2)}, ein vierdimensionale Vektorraum über dem Körper GF(2). Im Vektorraum V gibt es 16 verschiedene Vektoren, sagen wir v01 bis v16. Diese nummerieren wir beliebig durch.

Beispielhaft wird die folgende Nummerierung gewählt:
v01 = (0, 0, 0, 1),
v02 = (0, 0, 1, 0),
v03 = (0, 1, 0, 0),
v04 = (1, 0, 0, 0),
v05 = (0, 0, 1, 1),
v06 = (0, 1, 1, 0),
v07 = (1, 1, 0, 0),
v08 = (1, 0, 1, 1),
v09 = (0, 1, 0, 1),
v10 = (1, 0, 1, 0),
v11 = (0, 1, 1, 1),
v12 = (1, 1, 1, 0),
v13 = (1, 1, 1, 1),
v14 = (1, 1, 0, 1),
v15 = (1, 0, 0, 1),
v16 = (0, 0, 0, 0).

Zu konstruieren sind E=2 Untervektorräume von V mit F=4 Elementen, die sich nur im Nullvektor, hier v16, schneiden. Beispielhaft seien U1:={v01, v02, v05, v16} und U2:={v03, v04, v07, v16}. Es werden nun zu jedem Untervektorraum die 16 affinen Räume betrachtet, die man durch Translation des Unterraums um die verschiedenen 16 Vektoren erhält:
V011:= v01 + U1 = {v01, v02, v05, v16},
V021:= v02 + U1 = {v01, v02, v05, v16},
V031:= v03 + U1 = {v03, v06, v09, v11},
V041:= v04 + U1 = {v04, v08, v10, v15},
V051:= v05 + U1 = {v01, v02, v05, v16},
V061:= v06 + U1 = {v03, v06, v09, v11},
V071:= v07 + U1 = {v07, v12, v13, v14},
V081:= v08 + U1 = {v04, v08, v10, v15},
V091:= v09 + U1 = {v03, v06, v09, v11},
V101:= v10 + U1 = {v04, v08, v10, v15},
V111:= v11 + U1 = {v03, v06, v09, v11},
V121:= v12 + U1 = {v07, v12, v13, v14},
V131:= v13 + U1 = {v07, v12, v13, v14},
V141:= v14 + U1 = {v07, v12, v13, v14},
V151:= v15 + U1 = {v04, v08, v10, v15},
V161:= v16 + U1 = {v01, v02, v05, v16}
und
V012:= v01 + U2 = {v01, v09, v14, v15},
V022:= v02 + U2 = {v02, v06, v10, v12},
V032:= v03 + U2 = {v03, v04, v07, v16},
V042:= v04 + U2 = {v03, v04, v07, v16},
V052:= v05 + U2 = {v05, v08, v11, v13},
V062:= v06 + U2 = {v02, v06, v10, v12},
V072:= v07 + U2 = {v03, v04, v07, v16},
V082:= v08 + U2 = {v05, v08, v11, v13},
V092:= v09 + U2 = {v01, v09, v14, v15},
V102:= v10 + U2 = {v02, v06, v10, v12},
V112:= v11 + U2 = {v05, v08, v11, v13},
V122:= v12 + U2 = {v02, v06, v10, v12},
V132:= v13 + U2 = {v05, v08, v11, v13},
V142:= v14 + U2 = {v01, v09, v14, v15},
V152:= v15 + U2 = {v01, v09, v14, v15},
V162:= v16 + U2 = {v03, v04, v07, v16}.

Offensichtlich sind immer jeweils F=4 der affinen Räume identisch. Zwischen den jeweils D=4 verschiedenen affinen Räume pro Untervektorraum und den Summiermodulen der ersten und zweiten Ebene besteht eine eindeutige Korrespondenz, die die Anordnungen der Schaltnetze NI_1 bis NI_E beschreibt:
V011= {v01, v02, v05, v16} <==> SI_11, SII_11,
V031= {v03, v06, v09, v11} <==> SI_12, SII_12,
V041= {v04, v08, v10, v15} <==> SI_13, SII_13,
V071= {v07, v12, v13, v14} <==> SI_14, SII_14
und
V032= {v03, v04, v07, v16} <==> SI_21, SII_21,
V012= {v01, v09, v14, v15} <==> SI_22, SII_22,
V022= {v02, v06, v10, v12} <==> SI_23, SII_23
V052= {v05, v08, v11, v13} <==> SI_24, SII_24.

Die Eingangsanschlüsse I01, I02, I05, I16 werden mit dem Summiermodul SI_11 verknüpft. Die Eingangsanschlüsse I03, I06, I09, I11werden mit dem Summiermodul SI_12 verknüpft. Die Eingangsanschlüsse I04, I08, I10, I15 werden mit dem Summiermodul SI_13 verknüpft. Die Eingangsanschlüsse I07, I12, I13, I14 werden mit dem Summiermodul SI_14 verknüpft.

Äquivalent werden die Eingangsanschlüsse I03, I04, I07, I16 mit dem Summiermodul SI_21 verknüpft. Die Eingangsanschlüsse I01, I09, I14, I15 werden mit dem Summiermodul SI_22 verknüpft. Die Eingangsanschlüsse I02, I06, I10, I12 werden mit dem Summiermodul SI_23 verknüpft. Die Eingangsanschlüsse I05, I08, 111, 113 werden mit dem Summiermodul SI_24 verknüpft.

Anhand der obigen Korrespondenz zwischen den affinen Räumen und den Summiermodulen der ersten Ebene lassen sich die Anordnungen der Schaltnetze NII_1 bis NII_E herleiten. Es ist ersichtlich, dass jeder der 16 Vektoren in E=2 verschiedenen affinen Räumen enthalten ist:
v01 in V011 und V012;
v02 in V011 und V022;
bis hin zu v16 in V011 und V032.

Entsprechend dieser Eigenschaft wird das Entscheidungsmodul MII_1 mit den zu V011 und V012 korrespondierenden Summiermodulen SII_11 und SII_22 verknüpft. Das Entscheidungsmodul MII_2 wird mit den zu V011 und V022 korrespondierenden Summiermodulen SII_11 und SII_23 verknüpft. Dies wird schematisch bis hin zum Entscheidungsmodul MII_16 fortgesetzt. Das Entscheidungsmodul MII_16 wird dann mit den zu V011 und V032 korrespondierenden Summiermodulen SII_11 und SII_21 verknüpft.

### Literatur/Referenzen

(1) D. E. Muller, "Application of Boolean Algebra to Switching Circuit Design and to Error Detection," IRE Trans, EC-3: 6-12, September 1954.
(2) S. Reed, "A Class of Multiple-Error∼Correcting Codes and the Decoding Scheme," IRE Trans, IT-4: 38-49, September 1954.
(3) I. Dumer, "Recursive decoding and its performance for low-rate Reed-Muller codes," IEEE Trans. Inform. Theory, vol. 50, pp. 811-823, 2004.
(4) G. Schnabl and M. Bossert, "Soft-decision decoding of Reed-Muller codes as generalized multiple concatenated codes," IEEE Trans. Inform. Theory, vol. 41, pp. 304-308, 1995.
(5) S. Lin and D. J. Costello, "Error Control Coding: Fundamentals and Applications", Prentice-Hall, 1983.
(6) C.-L. Chen, "On majority-logic decoding of finite geometry codes," IEEE Trans. Inform. Theory, vol. 17, pp. 332-336, 1971.
(7) C.-L. Chen, "Note on majority-logic decoding of finite geometry codes," IEEE Trans. Inform. Theory, vol. 18, pp. 539-541, 1972.

## Patentansprüche

1. Anordnung zur Decodierung eines Datenworts mit Hilfe eines Reed-Muller-Codes oder eines dazu äquivalenten Codes, die aus folgenden Bauteilen besteht:
(1) N Eingangsanschlüsse, I1 bis IN,
(2) eine erste Ebene von E•D Summiermodulen, SI_11 bis SI_ED, wobei jedes Summiermodul der ersten Ebene mit F verschiedenen Eingangsanschlüssen und jeder Eingangsanschluss mit E Summiermodulen der ersten Ebene verknüpft ist,
(3) eine erste Ebene von E Entscheidungsmodulen, MI_1 bis MI_E, wobei jeder der D Eingänge jedes Entscheidungsmoduls mit jeweils einem Ausgang aus D verschiedenen Summiermodulen aus der ersten Ebene der Summiermodule verknüpft ist,
(4) eine zweite Ebene von H Summiermodulen, SII_1 bis SII_H, wobei jedes Summiermodul mit einem Entscheidungsmodul aus der ersten Ebene der Entscheidungsmodule und einem Summiermodul aus der ersten Ebene der Summiermodule verknüpft ist,
(5) eine zweite Ebene von G Entscheidungsmodulen, MII_1 bis MII_G, wobei jeder der E Eingänge jedes Entscheidungsmoduls mit jeweils einem Ausgang aus E verschiedenen Summiermodulen aus der zweiten Ebene der Summiermodule verknüpft ist,
(6) eine dritte Ebene von G Summiermodulen, SIII_1 bis SIII_G, wobei jedes Summiermodul mit genau einem Entscheidungsmodul aus der zweiten Ebene der Enscheidungsmodule und einem Eingangsanschluss verknüpft ist,
(7) G Ausgangsanschlüsse, O1 bis OG, wobei jeder Ausgangsanschluss mit genau einem Summiermodul aus der dritten Ebene der Summiermodule verknüpft ist, bei der N die Länge des Codes und D den Minimalabstand des Codes bedeuten, E gleich D-2, F gleich N/D, G die Anzahl der zu korrigierenden Symbole des Datenworts und H eine natürliche Zahl zwischen 1 und E•D sind.

2. Anordnung nach Anspruch 1), wobei H gleich E•D ist.

3. Anordnung nach einem der vorgehenden Ansprüche, wobei G gleich N oder G gleich der Dimension des Codes ist.

4. Anordnung nach einem der vorgehenden Ansprüche, wobei mindestens ein Summiermodul der zweiten und/oder dritten Ebene ein XOR-Gatter ist.

5. Anordnung nach einem der vorgehenden Ansprüche, wobei mindestens ein Entscheidungsmodul der zweiten Ebene ein AND-Gatter ist.

6. Anordnung nach einem der vorgehenden Ansprüche, wobei mindestens ein Summiermodul der ersten Ebene eine Odd-Parity-Funktion ausführt.

7. Anordnung nach einem der vorgehenden Ansprüche, wobei mindestens ein Entscheidungsmodul eine Majoritätsfunktion ausführt.

8. Anordnung nach einem der vorgehenden Ansprüche, wobei mindestens ein Entscheidungsmodul und/oder ein Summiermodul ein Logikgatter und/oder ein Quantenlogikgatter oder eine Anordnung mehrerer gleicher oder unterschiedlicher Logikgatter und/oder Quantenlogikgatter beinhaltet.

9. Verfahren zur Decodierung eines Datenworts mit Hilfe eines Reed-Muller-Codes oder eines dazu äquivalenten Codes, das folgende Schritte beinhaltet:
(1) das Einlesen des Datenworts, bestehend aus N Symbolen;
(2) das parallele Bilden von E•D Summen, wobei jede Summe aus F verschiedenen Symbolen des Datenworts aus (1) mit Hilfe eines Summiermoduls gebildet wird und jedes Symbol des Datenworts aus (1) zur Summenbildung von E Summen herangezogen wird;
(3) das parallele Ermitteln von E Entscheidungswerten, wobei jeder Entscheidungswert auf Basis von D durch verschiedene Summiermodule gebildete Summen aus (2) mit Hilfe eines Entscheidungsmoduls ermittelt wird und jede Summe aus (2) zur Ermittlung eines Entscheidungswerts herangezogen wird;
(4) das parallele Bilden von H Summen, wobei jede Summe aus einem der E Entscheidungswerte aus (3) und einer der E•D Summen aus (2) gebildet wird;
(5) das parallele Ermitteln von G Entscheidungswerten, wobei jeder Entscheidungswert auf Basis von E durch verschiedene Summiermodule gebildete Summen aus (4) mit Hilfe eines Entscheidungsmoduls ermittelt wird;
(6) das parallele Bilden von G Summen, wobei jede Summe aus einem der G Entscheidungswerte aus (5) und einem der N Symbole des Datenworts aus (1) gebildet wird;
(7) das Ausgeben der in (6) erzeugten Summen,
wobei N die Länge des Codes und D den Minimalabstand des Codes bezeichnen, E gleich D-2 ist, F gleich N/D ist und G die Anzahl der zu korrigierenden Symbole des Datenworts bezeichnet.

## Claims

1. An arrangement for decoding a data word by means of a Reed-Muller code or a code equivalent thereto, the arrangement comprising the following components:
(1) N input terminals, I1 to IN;
(2) a first level of E•D summing modules, SI_11 to SI_ED, wherein each summing module of the first level is linked with F different input terminals and each input terminal is linked with E summing modules of the first level;
(3) a first level of E decision modules, MI_1 to MI_E, wherein each of the D inputs of each decision module is linked with a respective output from D different summing modules from the first level of the summing modules;
(4) a second level of H summing modules, SII_1 to SII_H, wherein each summing module is linked with a decision module from the first level of the decision modules and a summing module from the first level of the summing modules;
(5) a second level of G decision modules, MII_1 to MII_G, wherein each of the E inputs of each decision module is linked with a respective output from E different summing modules from the second level of the summing modules;
(6) a third level of G summing modules, SIII_1 to SIII_G, wherein each summing module is linked with exactly one decision module from the second level of the decision modules and an input terminal;
(7) G output terminals, O1 to OG, wherein each output terminal is linked with exactly one summing module from the third level of the summing modules,
wherein N denotes the length of the code and D denotes the minimum distance of the code, E is equal to D-2, F is equal to N/D, G is the number of the symbols of the data word that are to be corrected, and H is a natural number between 1 and E•D.

2. The arrangement according to claim 1, wherein H is equal to E•D.

3. The arrangement according to any of the preceding claims, wherein G is equal to N, or G is equal to the dimension of the code.

4. The arrangement according to any of the preceding claims, wherein at least one summing module of the second level and/or third level is an XOR gate.

5. The arrangement according to any of the preceding claims, wherein at least one decision module of the second level is an AND gate.

6. The arrangement according to any of the preceding claims, wherein at least one summing module of the first level performs an odd-parity function.

7. The arrangement according to any of the preceding claims, wherein at least one decision module performs a majority function.

8. The arrangement according to any of the preceding claims, wherein at least one decision module and/or one summing module comprise(s) a logic gate and/or a quantum logic gate or an arrangement of a plurality of identical or different logic gates and/or quantum logic gates.

9. A method for decoding a data word by means of a Reed-Muller code or a code equivalent thereto, the method comprising the following steps:
(1) reading in the data word, consisting of N symbols;
(2) obtaining E•D sums in parallel, wherein each sum is formed from F different symbols of the data word from (1) using a summing module, and each symbol of the data word from (1) is considered for summing of E sums;
(3) determining of E decision values in parallel, wherein each decision value is determined on the basis of D sums from (2) formed by different summing modules using a decision module, and each sum from (2) is considered for determining a decision value;
(4) obtaining of H sums in parallel, wherein each sum is formed from one of the E decision values from (3) and one of the E•D sums from (2);
(5) determining of G decision values in parallel, wherein each decision value is determined on the basis of E sums from (4) formed by different summing modules using a decision module;
(6) obtaining of G sums in parallel, wherein each sum is formed from one of the G decision values from (5) and one of the N symbols of the data word from (1);
(7) outputting the sums generated in (6),
wherein N denotes the length of the code and D denotes the minimum distance of the code, E is equal to D-2, F is equal to N/D, and G is the number of the symbols of the data word that are to be corrected.

## Revendications

1. Système permettant le décodage d'un mot de données à l'aide d'un code de Reed-Muller ou d'un code équivalent à celui-ci, comprenant les composants suivantes :
(1) N bornes d'entrée, I1 à IN,
(2) un premier plan de E•D modules de sommation, SI_11 à SI_ED, dans lequel chaque module de sommation du premier plan est combiné à F bornes d'entrée différentes et chaque borne d'entrée est combinée à E modules de sommation du premier plan,
(3) un premier plan de E modules de décision, MI_1 à MI_E, dans lequel chacune des D entrées de chaque module de décision est respectivement combinée à une sortie de D modules de sommation différents du premier plan des modules de sommation,
(4) un deuxième plan de H modules de sommation, SII_1 à SII_H, dans lequel chaque module de sommation est combiné à un module de décision du premier plan des modules de décision et à un module de sommation du premier plan des modules de sommation,
(5) un deuxième plan de G modules de décision, MII_1 à MII_G, dans lequel chacune des E entrées de chaque module de décision est respectivement combinée à une sortie de E modules de sommation différents du deuxième plan des modules de somation,
(6) un troisième plan de G modules de sommation, SIII_1 à SIII_G, dans lequel chaque module de sommation est combiné à exactement un module de décision du deuxième plan des modules de décision et à une borne d'entrée,
(7) G bornes de sortie, O1 à OG, dans lequel chaque borne de sortie est combinée à exactement un module de sommation provenant du troisième plan des modules de sommation,
dans lequel N désigne la longueur du code et D désigne la distance minimale du code, E est égal à D-2, F est égal à N/D, G est le nombre des symboles à corriger du mot de données, et H est un entier naturel compris entre 1 et E•D.

2. Système selon la revendication 1, dans lequel H est égal à E•D.

3. Système selon l'une quelconque des revendications précédentes, dans lequel G est égal à N ou G est égal à la dimension du code.

4. Système selon l'une quelconque des revendications précédentes, dans lequel au moins un module de sommation du deuxième et/ou du troisième plan est une porte OU-EX.

5. Système selon l'une quelconque des revendications précédentes, dans lequel au moins un module de décision du deuxième plan est une porte ET.

6. Système selon l'une quelconque des revendications précédentes, dans lequel au moins un module de sommation du premier plan exécute une fonction de parité impaire.

7. Système selon l'une quelconque des revendications précédentes, dans lequel au moins un module de décision exécute une fonction de vote à la majorité.

8. Système selon l'une quelconque des revendications précédentes, dans lequel au moins un module de décision et/ou au moins un module de sommation comporte une porte logique et/ou une porte logique quantique ou un système constitué de plusieurs portes logiques et/ou portes logiques quantiques identiques ou différentes.

9. Procédé de décodage d'un mot de données à l'aide d'un code de Reed-Muller ou d'un code équivalent à celui--ci, comportant les étapes consistant à :
(1) lire en entrée le mot de données, constitué de N symboles,
(2) calculer en parallèle E•D sommes, dans lequel chaque somme est calculée à partir de F symboles différents du mot de données provenant de (1) à l'aide d'un module de sommation et chaque symbole du mot de données provenant de (1) est utilisé pour le calcul de E sommes ;
(3) obtenir en parallèle E valeurs de décision, dans lequel chaque valeur de décision est obtenue sur la base de D sommes provenant de (2) calculées par différents modules de sommation à l'aide d'un module de décision et chaque somme provenant de (2) est utilisée pour obtenir une valeur de décision ;
(4) calculer en parallèle H sommes, dans lequel chaque somme est calculée à partir de l'une des E valeurs de décision provenant de (3) et de l'une des E•D sommes provenant de (2) ;
(5) obtenir en parallèle G valeurs de décision, dans lequel chaque valeur de décision est obtenue sur la base de E sommes provenant de (4) calculées par différents modules de sommation à l'aide d'un module de décision ;
(6) calculer en parallèle G sommes, dans lequel chaque somme est calculée à partir de l'une des G valeurs de décision provenant de (5) et de l'un des N symboles du mot de données provenant de (1) ;
(7) délivrer en sortie les sommes générées en (6),
dans lequel N désigne la longueur du code et D désigne la distance minimale du code, E est égal à D-2, F est égal à N/D et G désigne le nombre des symboles à corriger du mot de données.
